# FASCICULE DE BREVET EUROPEEN

(11) **EP 0 630 987 B1**
(45) Date de publication et mention de la délivrance du brevet: **02.09.1998**
(21) Numéro de dépôt: 94401438.0
(22) Date de dépôt: 24.06.1994
(51) Int. Cl.: C23C 14/16, C23C 16/06, C25D 13/20

(54) **Procédé de revêtement de peinture par cataphorèse d'une pièce en acier galvanisé-allié**
Verfahren zur Beschichtung von verzinkten Stahl mittels kataphoretischer Lackierung
Process for coating galvanized steel by cataphoretic painting

(30) Priorité: 24.06.1993 FR 9307705
(43) Date de publication de la demande: 28.12.1994
(73) Titulaire: SOLLAC, 92800 Puteaux (FR)
(72) Inventeur: Choquet, Patrick, F-42100 Saint Etienne (FR); Guesdon, Philippe, F-75018 Paris (FR); Le Duc, Hiep, F-57000 Metz (FR)
(74) Mandataire: Moncheny, Michel

(56) Documents cités:
- EP-A- 0 047 987
- GB-A- 1 252 882
- US-A- 4 835 066
- PATENT ABSTRACTS OF JAPAN vol. 012, no. 047 (C-475) 12 Février 1988 & JP-A-62 192 597 (NIPPON STEEL CORP) 24 Août 1987
- DATABASE WPI Section Ch, Week 8750, Derwent Publications Ltd., London, GB; Class C23, AN 87-351473 & JP-A-62 253 762 (MITSUBISHI HEAVY IND KK) 5 Novembre 1987
- DATABASE WPI Section Ch, Week 9031, Derwent Publications Ltd., London, GB; Class M13, AN 90-235477 & JP-A-2 163 366 (NISSHIN ELECTRICAL KK) 22 Juin 1990
- DATABASE WPI Section Ch, Week 8926, Derwent Publications Ltd., London, GB; Class M13, AN 89-190103 & JP-A-1 129 962 (KOBE STEEL KK) 23 Mai 1989
- DATABASE WPI Section Ch, Week 9321, Derwent Publications Ltd., London, GB; Class A32, AN 93-172315 & JP-A-5 104 674 (KOBE STEEL LTD) 27 Avril 1993

## Description

La présente invention est relative à un procédé de revêtement de peinture par cataphorèse d'une pièce d'acier galvanisé-allié ainsi qu'à une pièce d'acier galvanisé-allié revêtue par ce procédé.

Dans le domaine des tôles d'acier revêtues, les tôles "galvanisées-alliées" sont des tôles en acier revêtues obtenues par immersion de la tôle dans un bain de zinc en fusion. A la suite du traitement, une partie du fer du substrat diffuse dans la couche de revêtement en zinc, de sorte que celle-ci contient une teneur en fer de l'ordre de 10%.

Ces tôles galvanisées-alliées sont principalement appliquées dans l'industrie automobile, en raison notamment d'une très bonne soudabilité, et sont mises en peinture pour cette application.

Lors du revêtement des tôles par une peinture, celles-ci sont soumises à plusieurs étapes : rinçage; phosphatation, rinçage, cataphorèse, finition.

Au cours de l'étape de cataphorèse, la tôle est immergée dans un bain contenant des molécules ou des particules de peinture, en suspension ou en solution dans l'eau, et à la mise sous tension du bain, un phénomène d'électrolyse se produit et provoque le revêtement de ladite tôle formant cathode par les espèces anioniques en solution.

Après cette étape, on a pu constater que la tôle ainsi revêtue présente des défauts de surface, ayant notamment l'apparence de petits cratères, et qui restent visibles malgré l'étape de finition ultérieure au cours de laquelle un apprêt et une laque sont appliqués sur ladite tôle revêtue.

Ce phénomène de cratérisation nuit donc à l'aspect esthétique de la tôle d'acier galvanisée-alliée peinte, et la rend inacceptable pour des applications telles que les carrosseries de véhicules automobiles. En outre, ces défauts affectent de manière significative la résistance à la corrosion atmosphérique des tôles d'acier galvanisées-alliées.

Pour résoudre le problème de mise en peinture par cataphorèse de tôle d'acier revêtues d'une couche de base en zinc ou en alliages de zinc, sans défauts, de cratérisation notamment, on connaît de EP-0 047 987 un procédé qui consiste à, préalablement à la mise en peinture, revêtir ladite tôle d'une couche de surface en alliage fer-zinc contenant plus de 60% en poids de fer.

En effet, il est indiqué dans ce document que des défauts de surface apparaissent dès que la teneur en fer de la couche de surface est inférieure à 60%.

Ainsi selon le procédé décrit dans EP-A-0 047 987, un couche mince de revêtement Fe-Zn à plus de 60% en fer est déposée sur la tôle généralement par voie électrolytique.

La mise en oeuvre d'un procédé électrolytique de dépôt présente l'inconvénient de nécessiter des installations coûteuses alors qu'un procédé de dépôt sous-vide peut être plus économique.

Pour le dépôt sous vide d'un alliage Fe-Zn on procède généralement en évaporant du zinc et du fer placés dans deux creusets séparés; l'évaporation du zinc est réalisée d'une façon économique, par chauffage notamment par effet Joule, mais celle du fer, moins volatil, nécessite plus d'énergie et est réalisée généralement par bombardement électronique, surtout lorsque la teneur en fer du dépôt souhaité est élevée et lorsque l'on souhaite des vitesses de dépôt élevées pour une production industrielle.

Pour le dépôt sous vide d'un alliage Fe-Zn à plus de 60% en poids de fer selon EP-A-0 047 987, la puissance utile de bombardement électronique, proportionnelle à la teneur en fer du dépôt, est élevée. De ce fait, un tel procédé de traitement sous vide est trop coûteux et n'est pas avantageux par rapport à un procédé de dépôt électrolytique.

La présente invention a pour but de résoudre de façon économique le problème de cratérisation lors de la mise en peinture par cataphorèse et est basée sur la découverte que, contrairement à l'enseignement de EP-A-0 047 987, l'application d'un revêtement fer-zinc contenant moins de 60% de fer en poids déposé sous vide sur la surface d'une pièce en acier galvanisé-allié préalablement à la mise en peinture de ladite pièce par cataphorèse permet d'obtenir une pièce peinte ayant une surface sans défauts, notamment de type cratère, et de surcroît sans rugosités ce qui lui confère un aspect amélioré.

L'emploi d'une technique de dépôt sous vide pour réaliser des dépôts à faible teneur en fer permet de diminuer significativement le coût du traitement avant la mise en peinture.

A cet effet, l'invention a pour objet un procédé de revêtement de peinture par cataphorèse d'une pièce d'acier galvanisé-allié caractérisé en ce que l'on dépose sous vide sur au moins une face de ladite pièce, préalablement à sa mise en peinture, une couche de revêtement de surface en alliage fer-zinc dont la teneur pondérale en fer est inférieure à 60%.

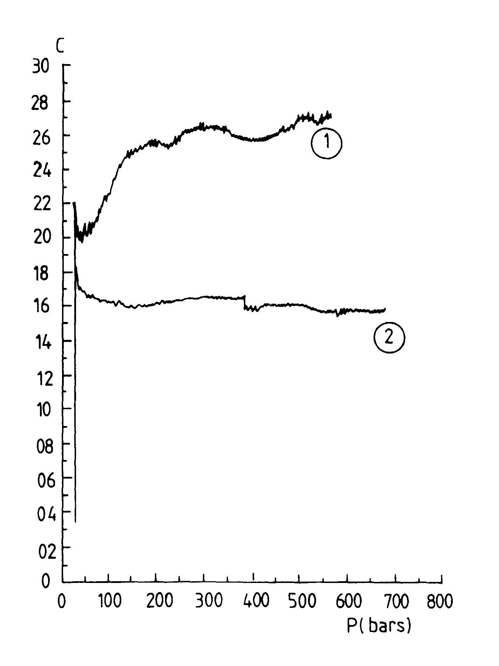

La figure unique est un graphique illustrant les résultats d'un test de frottement d'une tôle revêtue selon l'invention.

D'autres caractéristiques et avantages de l'invention apparaîtront au cours de la description qui va suivre, donnée uniquement à titre d'exemple non limitatif.

Le procédé selon l'invention s'applique à une pièce en acier galvanisé-allié, comme par exemple une tôle d'acier galvanisée-alliée.

Une tôle d'acier galvanisée-alliée est obtenue de manière classique par immersion de ladite tôle d'acier dans un bain de zinc en fusion et par traitement thermique de la tôle ainsi revêtue.

A la suite du traitement thermique, une partie du fer du substrat diffuse dans le revêtement de zinc, de sorte que celui-ci contient, après traitement, une teneur pondérale en fer de l'ordre de 10%.

Classiquement, sur une tôle d'acier d'épaisseur égale à 0,7 mm, on obtient un revêtement d'environ 6,5 µm d'épaisseur.

Dans une première étape du procédé de revêtement de peinture selon l'invention, on effectue le dépôt sous vide sur au moins une face d'une pièce d'acier galvanisée-alliée obtenue comme précédemment, d'un revêtement fer-zinc dont la teneur pondérale en fer est d'au plus 60%.

Avantageusement, le revêtement fer-zinc contient au moins 5% de fer. En effet le procédé s'applique à des pièces d'acier galvanisé-allié. L'avantage de ce type d'acier est sa bonne soudabilité due à la présence de fer dans la couche superficielle. Ainsi, pour que la pièce garde une bonne soudabilité après sa mise en peinture, il est préférable que le revêtement déposé sous vide contienne une quantité suffisante de fer. Cependant la mise en peinture se fait de façon aussi satisfaisante sans cratérisation après le dépôt sous vide d'un revêtement contenant moins de 5% de fer.

De préférence, la teneur en fer est inférieure à 50%.

Le dépôt sous vide peut être effectué par voie chimique ou par voie physique suivant l'une des techniques connues sous le sigle PVD (Physical Vapor Deposition). Selon un premier mode de réalisation de l'invention, ce dépôt est plus particulièrement effectué par évaporation sous vide dans une enceinte soumise à une pression comprise entre 10⁻⁸ et 10²Pa, de préférence comprise entre 10⁻³ et 10⁻¹Pa, et par exemple égale à 5.10⁻³Pa.

La pièce en acier galvanisé-allié est placée dans une enceinte sous vide dans laquelle on provoque l'évaporation d'au moins un corps contenant les matériaux destinés à former le revêtement, et par exemple de fer et de zinc contenu dans un creuset et dont les teneurs pondérales respectives permettent d'obtenir les teneurs visées dans le revêtement final.

De préférence, on procède à l'évaporation séparément, dans deux creusets différents dont l'un contient du zinc et l'autre contient du fer, en des proportions permettant d'obtenir les teneurs visées dans le revêtement final.

Il est également possible de provoquer l'évaporation séparée et successive de zinc contenu dans un creuset et de fer contenu dans un autre creuset, en interposant sur le passage des vapeurs de fer un diaphragme dont la position est adaptée à la composition visée au revêtement de la pièce d'acier galvanisée-alliée en défilement, disposée en regard desdits creusets.

L'évaporation est provoquée par chauffage au moyen d'une résistance (effet Joule) électrique, par induction ou par bombardement électronique. En pratique, le fer qui est beaucoup moins volatil que le zinc, est soumis à un bombardement électronique, alors que le zinc peut être évaporé au moyen de l'une quelconque de ces techniques et en particulier au moyen d'une résistance chauffante. Les matériaux à évaporer sont contenus sous forme solide ou en poudre chacun dans un creuset métallique ou céramique, et sont chauffés à leur surface à des températures supérieures ou égales à 400°C pour le zinc et 1600°C pour le fer et par exemple égale à 500°C pour le zinc, au moyen d'une résistance chauffante et égale à 1800°C pour le fer, autour du point d'impact du faisceau d'électrons émis par un canon à électrons.

Les atomes ou groupements d'atomes de zinc et de fer vont, après évaporation, se condenser sur la surface de la pièce d'acier galvanisée-alliée, afin de former un revêtement fer-zinc de teneur pondérale en fer comprise entre 5 et 60%, et dont l'épaisseur est inférieure ou égale à 1 µm et par exemple égale à 0,5 µm. Le temps d'exposition de la pièce d'acier galvanisée-alliée à l'atmosphère gazeuse de fer et de zinc dépend évidemment de l'épaisseur du revêtement souhaité.

Le procédé de traitement selon l'invention peut s'appliquer dans le cadre de la mise en peinture en continu de pièces en acier galvanisé-allié et notamment de tôles d'acier galvanisées-alliées. Le dépôt sous vide s'effectue donc en continu, la tôle défilant dans l'enceinte d'évaporation sous vide. Les creusets contenant le fer et le zinc sont disposés en regard de la tôle en défilement.
La vitesse de défilement de la tôle d'acier galvanisée alliée est par exemple égale ou supérieure à 10 m/mn.

Suivant une forme de réalisation avantageuse de l'invention, préalablement au dépôt du revêtement de fer-zinc, on soumet la surface de la pièce galvanisée-alliée à un prénettoyage par bombardement ionique dans un gaz neutre (Ar, Xe, Kr) ou dans un gaz réactif (O₂, F₂, H₂, N₂, hydrocarbures volatils) ou dans un mélange gazeux formé d'au moins un gaz neutre et/ou d'au moins un gaz réactif.

Par exemple, le prénettoyage par bombardement ionique est effectué dans l'argon.

L'énergie des ions est avantageusement comprise entre 200 et 2000 eV, de préférence comprise entre 500 et 1200 eV et, par exemple égale à 800 eV. La densité de courant ionique est comprise entre 0,4 et 5 mA/cm² et par exemple égale à 2 mA/cm².

Ce traitement, qui ne doit pas être excessivement long et, en général ne doit pas dépasser 4mn afin de ne pas chauffer la pièce d'acier galvanisée-alliée à une température supérieure à 250°C, améliore l'adhérence du revêtement fer-zinc sur ladite tôle.

Suivant une autre caractéristique avantageuse possible de l'invention, on réalise simultanément au dépôt du revêtement fer-zinc un bombardement ionique de la surface de la pièce d'acier galvanisée-alliée à partir d'un gaz neutre (Ar, Xe, Kr) ou d'un gaz réactif (O₂, F₂ H₂, N₂, hydrocarbures volatils) ou d'un mélange gazeux formé d'au moins un gaz neutre et/ou d'au moins un gaz réactif.

Ces gaz peuvent être différents de ceux utilisés pour la phase de prénettoyage ionique, et l'on utilise par exemple de l'argon.

Les énergies et densités de courant ionique pour cette phase sont du même ordre de grandeur que celles de la phase de prénettoyage ionique et sont par exemple respectivement égales à 800 eV et 2 mA/cm² pour une tôle qui défile à 10 m/mn.

Cette phase de bombardement ionique simultanée au dépôt du revêtement d'alliage fer-zinc permet d'obtenir un revêtement très dense. Avantageusement, on peut combiner la phase de bombardement ionique à une phase de prénettoyage ionique.

Selon un deuxième mode de réalisation de l'invention, le dépôt sous vide peut être effectué par pulvérisation ionique d'au moins une cible contenant les matériaux destinés à former le revêtement fer-zinc.

La pièce en acier galvanisé-allié revêtue d'un alliage fer-zinc par une des t:echniques selon l'invention exposées précédemment est ensuite soumise à une opération de mise en peinture par cataphorèse d'une façon connue en soi. La pièce revêtue peut être préparée avant cette opération de cataphorèse en effectuant diverses opérations largement connues de l'art antérieur : dégraissage alcalin, rinçage, affinage, phosphatation tricationique, rinçage, passivation chromique, rinçage, étuvage.

La Demanderesse s'est aperçue de manière tout à fait inattendue, étant donné l'enseignement technique contenu dans le brevet européen n° 0.047.987, que malgré l'apparition de cristaux d'hopéite lors de la phosphatation de la pièce d'acier galvanisée-alliée revêtue par le procédé selon l'invention, on ne constate aucun cratère pendant et après l'opération de cataphorèse.

En outre, un tel revêtement fer-zinc selon l'invention améliore l'aspect de la pièce d'acier galvanisée-alliée après sa mise en peinture, qui ne présente notamment pas de rugosités.

Le procédé de l'invention est sans aucun danger pour l'environnement et, compte tenu des faibles épaisseurs déposées sur les pièces d'acier galvanisées-alliées, un tel procédé est rapide et donc avantageux d'un point de vue industriel.

Les pièces en acier galvanisé-allié à mettre en peinture par le procédé de l'invention peuvent être des tôles ou des pièces formées, notamment des pièces embouties. Il a été constaté qu'une pièce formée mise en peinture selon l'invention est avantageusement obtenue en utilisant de la tôle d'acier galvanisée-alliée, soumettant ladite tôle au dépôt sous vide d'un revêtement fer-zinc, emboutissant la tôle revêtue ainsi obtenue pour former une pièce emboutie que l'on revêt de peinture par cataphorèse.

En effet, les revêtements fer-zinc déposés sur les tôles d'acier galvanisées-alliées confèrent à leur surface une diminution du coefficient de frottement, et facilitent ainsi une mise en forme ultérieure desdites tôles d'acier galvanisées-alliées revêtues selon le procédé de l'invention, comme par exemple une opération d'emboutissage, avant la mise en peinture des pièces formées ainsi obtenues.

L'invention a donc également pour objet un procédé de revêtement de peinture par cataphorèse d'une pièce en acier galvanisé-allié caractérisé en ce que l'on dépose sous vide sur une pièce d'acier galvanisé-allié un revêtement fer-zinc comme exposé précédemment, puis on met en forme la pièce ainsi revêtue, notamment par emboutissage, et l'on soumet la pièce emboutie ainsi obtenue à une opération de peinture par cataphorèse.

Dans le cadre de la mise en oeuvre d'un procédé de revêtement de peinture tel que décrit ici, l'invention a également pour objet l'utilisation d'une pièce en acier revêtue d'une couche de base et d'une couche de surface, ladite couche de base étant constituée de zinc ou d'un alliage à base de zinc et ladite couche de surface étant constituée d'un revêtement fer-zinc déposé sous vide dont la teneur pondérale en fer est inférieure à 60%, pour un revêtement de peinture par cataphorèse.

La présente invention a également pour objet une pièce d'acier peinte comprenant un substrat en acier, une couche de base constituée de zinc ou d'un alliage à base de zinc déposée sur ledit substrat, une couche de surface recouvrant ladite couche de base et une couche extérieure de peinture, caractérisée en ce que ladite couche de surface est constituée d'un alliage fer-zinc déposé sous vide dont la teneur pondérale en fer est inférieure à 60% et en ce que ladite couche de peinture est appliquée sur ladite couche de surface par cataphorèse.

Les essais ci-après vont illustrer les différentes propriétés de tôles d'acier galvanisées-alliées revêtues de fer-zinc selon l'invention et les avantages qui en découlent.

### Essai 1.

L'essai a pour but de montrer la résistance au phénomène de cratérisation de tôles d'acier galvanisées alliées revêtues de fer et de zinc selon l'invention lors de l'opération de cataphorèse.

L'essai est effectué sur des échantillons de tôles d'acier galvanisé-allié mesurant 100 mm x 100 mm obtenus de manière classique par immersion des échantillons dans un bain de zinc en fusion, et par traitement thermique desdits échantillons ainsi revêtus. On obtient sur chaque échantillon une épaisseur de revêtement de l'ordre de 6,5 µm, la teneur en fer du revêtement étant voisine de 10% et l'épaisseur de la tôle d'acier avant revêtement étant de 0,7 mm.

On dispose de différents échantillons de tôles d'acier galvanisées alliées dont l'un sert de témoin.

Chacun des échantillons, excepté le témoin, est placé dans une enceinte sous vide dont l'atmosphère est à une pression de 10⁻³Pa.

Au préalable, on soumet les faces à revêtir de l'échantillon à un prénettoyage par bombardement ionique à l'argon, avec une énergie ionique de 500 eV et une densité de courant ionique de 0,2 mA/cm².

Deux creusets contenant l'un du zinc et l'autre du fer sont disposés côte à côte au-dessous de la surface à revêtir de l'échantillon.

On vient provoquer simultanément l'évaporation du fer au moyen d'un canon à électrons et l'évaporation du zinc par chauffage par effet Joule dans un four à résistance dont la température du bain est comprise entre 400 et 600°C, de préférence comprise entre 500 et 550°C et par exemple égale à 525°C.

Selon sa position par rapport à chacun des creusets, un point de la surface de l'échantillon sera plus ou moins exposé aux vapeurs de l'un ou l'autre des deux métaux.

Les points de la surface situés plus près du creuset de fer recevront plus de fer que ceux situés plus près du creuset de zinc et inversement.

En une seule opération on dépose sur la surface de l'échantillon toute une variété de revêtements fer-zinc.

De cette manière, le revêtement déposé présente une teneur pondérale en fer qui varie linéairement de 5 à 80% d'une extrémité à l'autre de l'échantillon.

On réalise ainsi plusieurs opérations de dépôts sous vide afin d'obtenir des échantillons avec des revêtements fer-zinc, d'épaisseur allant de 0,1 à 1 µm pour des teneurs pondérales en fer variant entre 5 et 80%.

Ensuite, on effectue sur les échantillons les opérations suivantes : dégraissage alcalin, rinçage, affinage, phosphatation tricationique, rinçage, passivation chromique, rinçage, étuvage.

Les échantillons sont ensuite soumis à une opération de cataphorèse de type PPG ED4 717/958 permettant d'appliquer une première couche de peinture d'épaisseur égale à 20 µm sur chacun d'eux.

L'essai pratiqué sur tous les échantillons consiste, lors de l'opération de cataphorèse, à appliquer différentes tensions électriques à l'électrolyte, et à relever pour chaque tension appliquée le nombre de cratères par cm² apparaissant sur les échantillons.

Ainsi, pour une tension appliquée de 215 V, l'échantillon témoin présente de 1 à 5 cratères par cm², alors qu'aucun cratère n'est visible sur les autres échantillons.

A 300 V, la densité de cratères sur l'échantillon témoin est de l'ordre de 50/cm² alors que les autres échantillons ne présentent toujours aucun cratère.

Les échantillons phosphatés sont observés en microscopie électronique à balayage avant cataphorèse.

On constate que pour une teneur en fer de 45% les cristaux de phosphate sont des cristaux d'hopéite et que pour une teneur en fer de 80% ce sont des cristaux de phosphophilite. A partir d'environ 70% il n'y a plus de cristaux d'hopéite et les cristaux de phosphophilite apparaissent à partir d'environ 50%.

Un revêtement fer-zinc d'épaisseur inférieure ou égale à 1 µm et de teneur pondérale en fer inférieure à 60% déposé sous vide selon l'invention permet donc d'éviter la formation de cratères tout en présentant des cristaux de phosphates de type hopéite.

### Essai 2.

Cet essai vise à illustrer, à travers un test de frottement, la facilité de mise en oeuvre d'une tôle d'acier galvanisée-alliée revêtue de fer et de zinc selon le procédé de l'invention.

L'essai est effectué sur deux échantillons de tôles d'acier galvanisé-allié, notés 1 et 2, mesurant 100 mm x 100 mm obtenus de manière classique par immersion des échantillons dans un bain de zinc en fusion et par traitement thermique desdits échantillons ainsi revêtus. On obtient sur chaque échantillon une épaisseur de revêtement de l'ordre de 6,5 µm, la teneur en fer du revêtement étant voisine de 10% et l'épaisseur de la tôle d'acier avant revêtement étant de 0,7 mm.

On dispose l'un des deux échantillons noté 2 dans une enceinte sous vide dont l'atmosphère est à une pression de 10⁻³Pa, l'autre échantillon noté 1 servant de témoin.

Au préalable, on soumet les faces à revêtir de l'échantillon 2 à un prénettoyage par bombardement ionique à l'argon, avec une énergie de 500 eV et une densité de courant ionique de 0,2 mA/cm².

Deux creusets contenant l'un du zinc et l'autre du fer sont disposés côte à côte au-dessous de la surface à revêtir de l'échantillon.

On vient provoquer simultanément l'évaporation du fer au moyen d'un canon à électrons et l'évaporation du zinc par chauffage par effet Joule dans un four à résistance dont la température du bain est comprise entre 400 et 600°C, de préférence comprise entre 500 et 550°C et par exemple égale à 525°C.

De manière analogue au dépôt de l'essai 1, le revêtement déposé présente une teneur pondérale en fer qui varie linéairement de 5 à 80% d'une extrémité à l'autre de l'échantillon.

L'épaisseur de ce dépôt est de 0,5 µm.

Le test de frottement consiste à placer chacun des échantillons 1 et 2 verticalement entre deux outils qui exercent sur lesdits échantillons, au moyen d'un vérin hydraulique, un effort de serrage variable correspondant à la pression d'emboutissage habituellement utilisée, et simulant le contact avec un serre-flan et une matrice au cours d'une opération d'emboutissage.

Simultanément, les échantillons sont tirés verticalement vers le haut à vitesse constante égale à 0,1 m/mn et avec une force proportionnelle à l'effort d'emboutissage au moyen d'un autre vérin hydraulique.

Préalablement à la mise en oeuvre de cet essai, on lubrifie les différents éléments amenés à entrer en contact l'un avec l'autre au moyen d'huile de type SHELL 2769E.

Pour chaque échantillon, on mesure à chaque pression d'emboutissage P le coefficient de frottement C entre ledit échantillon et les outils et l'on reporte les résultats obtenus sur le graphique de la figure unique annexée, sur laquelle on voit que le coefficient de frottement C (en ordonnées) de l'échantillon 1 a une valeur initiale de l'ordre de 0,20 qui croît jusqu'à environ 0,27, pour une pression P (en abscisses) égale à 500 bars, traduisant ainsi le phénomène du grippage. Le coefficient de frottement initial de l'échantillon 2 est légèrement inférieur à 0,2 et diminue au cours de l'emboutissage jusqu'à atteindre une valeur de l'ordre de 0,16 pour une pression égale à 500 bars.

Par conséquent, le dépôt d'un revêtement fer-zinc conforme à l'invention sur une tôle d'acier galvanisée alliée provoque une diminution importante du coefficient de frottement de la tôle ainsi revêtue, retardant donc l'apparition du phénomène de grippage et facilitant la mise en forme de cette tôle.

Après la mise en forme, la tôle peut être revêtue d'une couche de peinture par cataphorèse comme dans l'essai 1 pour obtenir une pièce formée peinte sans défaut de surface.

## Revendications

1. Procédé de revêtement de peinture par cataphorèse d'une pièce en acier galvanisé-allié, caractérisé en ce que l'on dépose sous vide sur au moins une face de ladite pièce, préalablement à sa mise en peinture, une couche de revêtement de surface en alliage fer-zinc dont la teneur pondérale en fer est inférieure à 60%.

2. Procédé selon la revendication 1, caractérisé en ce que la teneur pondérale en fer du revêtement fer-zinc est de 5 à 50%.

3. Procédé selon la revendication 1 ou 2, caractérisé en ce que le revêtement fer-zinc a une épaisseur au plus égale à 1 µm.

4. Procédé selon l'une quelconque des revendications 1 à 3, caractérisé en ce que le dépôt sous vide est effectué par évaporation d'au moins un corps contenant les matériaux destinés à former le revêtement.

5. Procédé selon l'une quelconque des revendications 1 à 4, caractérisé en ce que l'évaporation est provoquée par chauffage par effet Joule, induction ou bombardement électronique.

6. Procédé selon l'une des revendications 1 à 5, caractérisé en ce que, préalablement au dépôt du revêtement fer-zinc, on soumet la face du substrat d'acier galvanisé allié à un bombardement ionique dans un gaz ou un mélange gazeux formé d'au moins un gaz neutre et/ou d'au moins un gaz réactif.

7. Procédé selon l'une quelconque des revendications 1 à 5, caractérisé en ce que, simultanément au dépôt du revêtement fer-zinc,on soumet la face du substrat d'acier galvanisé allié à un bombardement ionique dans un gaz ou un mélange gazeux formé d'au moins un gaz neutre et/ou d'au moins un gaz réactif.

8. Procédé selon l'une quelconque des revendications 1 à 7, caractérisé en ce que la pièce en acier galvanisé-allié revêtue dudit alliage fer-zinc est mise en forme, notamment par emboutissage, avant d'être soumise à l'opération de cataphorèse.

9. Utilisation d'une pièce en acier revêtue d'une couche de base et d'une couche de surface, ladite couche de base étant constituée de zinc ou d'un alliage à base de zinc et ladite couche de surface étant constituée d'un alliage fer-zinc déposé sous vide dont la teneur pondérale en fer est inférieure à 60%, pour un revêtement de peinture par cataphorèse.

10. Utilisation d'une pièce en acier revêtue selon la revendication 9, dans laquelle ladite couche de surface présente une épaisseur au plus égale à 1 µm.

11. Utilisation d'une pièce en acier revêtue selon la revendication 9 ou 10, dans laquelle ladite pièce est mise en forme, notamment par emboutissage, préalablement à sa mise en peinture.

12. Pièce d'acier revêtue d'une peinture comprenant un substrat d'acier, une couche de base constituée de zinc ou d'un alliage de zinc déposée sur ce substrat, une couche de surface recouvrant ladite couche de base et une couche extérieure de peinture, caractérisée en ce que ladite couche de surface est constituée d'un alliage fer-zinc déposé sous vide dont la teneur pondérale en fer est inférieure à 60% et en ce que ladite couche de peinture est appliquée sur ladite couche de surface par cataphorèse.

13. Pièce d'acier selon la revendication 12, caractérisée en ce que ladite couche de surface présente une épaisseur au plus égale à 1 µm.

14. Pièce d'acier selon l'une quelconque des revendications 11 ou 12, caractérisée en ce que ladite pièce est une pièce mise en forme, notamment par emboutissage, avant mise en peinture.

## Patentansprüche

1. Verfahren zur Beschichtung eines verzinkten Stahlteils mittels kataphoretischer Lackierung, dadurch gekennzeichnet, daß vor der Lackierung mindestens eine Seite des verzinkten Teils unter Vakuum mit einer Oberflächenbeschichtung aus einer Eisen-Zink-Legierung überzogen wird, deren Eisen-Gewichtsgehalt unter 60 % liegt.

2. Verfahren nach Anspruch 1, dadurch gekennzeichnet, daß der Eisen-Gewichtsgehalt der Eisen-Zink-Beschichtung 5 bis 50 % beträgt.

3. Verfahren nach Anspruch 1 oder 2, dadurch gekennzeichnet, daß die Eisen-Zink-Beschichtung eine Stärke von höchstens 1 µm hat.

4. Verfahren nach einem der Ansprüche 1 bis 3, dadurch gekennzeichnet, daß der Überzug unter Vakuum durch Verdampfung mindestens eines Körpers erfolgt, der die Stoffe enthält, die die Beschichtung bilden sollen.

5. Verfahren nach einem der Ansprüche 1 bis 4, dadurch gekennzeichnet, daß die Verdampfung durch Joulesche Heizung, Induktion oder Elektronenbeschuß bewirkt wird.

6. Verfahren nach einem der Ansprüche 1 bis 5, dadurch gekennzeichnet, daß vor dem Auftrag der Eisen-Zink-Beschichtung die Seite des Substrats aus verzinktem Stahl einem Ionenbeschuß in einem Gas oder einem Gasgemisch, das wenigstens aus einem Neutralgas und/oder wenigstens einem Reagenzgas besteht, unterzogen wird.

7. Verfahren nach einem der Ansprüche 1 bis 5, dadurch gekennzeichnet, daß gleichzeitig mit dem Auftrag der Eisen-Zink-Beschichtung die Seite des Substrats aus verzinktem Stahl einem Ionenbeschuß in einem Gas oder einem Gasgemisch, das aus mindestens einem Neutralgas und/oder mindestens einem Reagenzgas besteht, unterzogen wird.

8. Verfahren nach einem der Ansprüche 1 bis 7, dadurch gekennzeichnet, daß das mit der Eisen-Zink-Legierung beschichtete Teil aus verzinktem Stahl insbesondere durch Tiefziehen geformt wird, bevor es dem kataphoretischen Vorgang unterzogen wird.

9. Verwendung eines Stahlteils, das mit einer Grundschicht und einer Oberflächenschicht beschichtet ist, wobei die Grundschicht aus Zink oder einer Legierung auf Zinkbasis besteht und die Oberflächenschicht für eine kataphoretische Lackierung aus einer unter Vakuum aufgebrachten Eisen-Zink-Legierung mit einem Eisen-Gewichtsgehalt von weniger als 60 % besteht.

10. Verwendung eines gemäß Anspruch 9 beschichteten Stahlteils, wobei die Obeflächenschicht eine Stärke von höchstens 1 µm aufweist.

11. Verwendung eines gemäß Anspruch 9 oder 10 beschichteten Stahlteils, wobei das Teil vor der Lackierung insbesondere durch Tiefziehen geformt wird.

12. Mit Farbe überzogenes Stahlteil, welches ein Stahlsubstrat, eine aus Zink oder einer Zinklegierung bestehende und auf dieses Substrat aufgebrachte Grundschicht, eine die Grundschicht bedeckende Oberflächenschicht und eine äußere Farbschicht umfaßt, dadurch gekennzeichnet, daß die Oberflächenschicht aus einer unter Vakuum aufgebrachten Eisen-Zink-Legierung besteht, deren Eisen-Gewichtsgehalt unter 60 % liegt, und daß die Farbschicht durch Kataphorese auf die Oberflächenschicht aufgebracht wird.

13. Stahlteil gemäß Anspruch 12, dadurch gekennzeichnet, daß die Oberflächenschicht eine Stärke von höchstens 1 µm aufweist.

14. Stahlteil nach einem der Ansprüche 11 oder 12, dadurch gekennzeichnet, daß das Teil vor der Lackierung insbesondere durch Tiefziehen geformt wird.

## Claims

1. Process for coating a part made of galvanized-alloyed steel with paint by cataphoresis characterized in that a surface-coating layer of iron-zinc alloy of which the content by weight of iron is less than 60% is deposited under vacuum on at least one face of said part, before it is painted.

2. Process according to Claim 1, characterized in that the content by weight of iron of the iron-zinc coating is between 5 and 50%.

3. Process according to Claim 1 or 2, characterized in that the thickness of the iron-zinc coating is at most 1 µm.

4. Process according to any one of Claims 1 to 3, characterized in that the deposition under vacuum is carried out by evaporating at least one part containing the materials for forming the coating.

5. Process according to any one of Claims 1 to 4, characterized in that evaporation is brought about by heating by the Joule effect, induction or electron bombardment.

6. Process according to any one of Claims 1 to 5, characterized in that, before the iron-zinc coating is deposited, the face of the galvanized-alloyed steel substrate is subjected to ion bombardment in a gas or gaseous mixture consisting of at least one neutral gas and/or at least one reactive gas.

7. Process according to any one of Claims 1 to 5, characterized in that, at the same time as the iron-zinc coating is deposited, the face of the alloyed galvanized steel substrate is subjected to ion bombardment in a gas or gaseous mixture consisting of at least one neutral gas and/or at least one reactive gas.

8. Process according to any one of Claims 1 to 7, characterized in that the galvanized-alloyed steel part coated with said iron-zinc alloy is shaped, in particular by pressing **,** before being subjected to the cataphoresis operation.

9. Use of a steel part coated with a base layer and a surface layer, said base layer consisting of zinc or a zinc-based alloy and the surface layer consisting of an iron-zinc alloy which is deposited under vacuum and of which the content by weight of iron is less than 60%, for coating with paint by cataphoresis.

10. Use of a coated steel part according to Claim 9, wherein said surface layer is at most 1 µm thick.

11. Use of a coated steel part according to Claim 9 or 10, wherein said part is shaped, in particular by pressing, before being painted.

12. Steel part coated with paint and comprising a steel substrate, a base layer consisting of zinc or a zinc-alloy and deposited onto this substrate, a surface layer covering said base layer and an outer coat of paint, characterized in that said surface layer consists of an iron-zinc alloy which is deposited under vacuum and of which the content by weight of iron is less than 60%; and in that said coat of paint is applied to said surface layer by cataphoresis.

13. Steel part according to Claim 12, characterized in that the thickness of said surface layer is at most 1 µm.

14. Steel part according to either of Claims 11 and 12, characterized in that said part is shaped, in particular by pressing, before being painted.
